# EUROPEAN PATENT APPLICATION

(11) **EP 4 831 598 A1**
(43) Date of publication of application: **28.10.2026**
(21) Application number: 25172743.4
(22) Date of filing: 25.04.2025
(51) Int. Cl.: G01H 9/00, G01R 31/08

(54) **METHOD FOR MONITORING A LINE SYSTEM, AND MONITORING SYSTEM FOR IMPLEMENTING THIS METHOD**

(71) Applicant: EOSS SA, 1110 Morges (CH)
(72) Inventor: ROCHAT, Etienne, 1110 MORGES (CH)
(74) Representative: IPAZ

(57) **Abstract**

The invention concerns a method for monitoring a line transmission system (2), the line transmission system comprising two supporting structures (21, 22) distant from each other, one optical fiber (3) carried by the two distant supporting structures, at least one electrical conductor wire (4) carried by the two distant supporting structures; the method comprising: measuring at least one physical parameter of the optical fiber, of surroundings of the optical fiber, of the at least one electrical conductor wire, and/or of surroundings of the at least one electrical conductor wire; measuring a measured frequency spectrum of oscillations of the optical fiber between the two supporting structures, and/or a measured frequency spectrum of oscillations of the at least one electrical conductor wire between the two supporting structures; deducing a perturbation on the line transmission system, based on the measured frequency spectrum.

The invention also relates to a monitoring system (1) for implementing this method.

## Description

### Technical field

The present invention relates to a method for monitoring a line transmission system.

The invention also relates to a monitoring system for implementing this method.

### State of the Art

The question of monitoring an electrical line transmission system is very important for example to verify that the transmission of electricity is efficient and without loss, to ensure that the operation of the line transmission system remains stable, and to identify any incidents that could cause problems such as structural damage or safety issues.

For example, if electrical current is too big, then the line can go down, because the line is warmer, and due to dilation, the line length becomes longer. At some point, the situation can even become unsafe, as for example clearance cannot be guaranteed anymore.

Typical problems are for example that:
- the sag of the line can be difficult to compute, as it depends upon various parameters of the environment of the line,
- many existing measuring methods are unable to distinguish between different types of disturbance or damage on the line other than by visual observation by human or camera or drone.

The goal of the invention is to present a monitoring method or monitoring system for monitoring a line transmission system, allowing for better measurement accuracy and/or distinction between different types of disturbance or damage or defaults on the line transmission system (and preferably allowing to localize each disturbance or damage or defaults) without the necessity of direct visual observation by human or camera or drone.

### Summary of the Invention

An aspect of the invention concerns a method for monitoring a line transmission system, the line transmission system comprising :
- two supporting structures distant from each other,
- one optical fiber carried by the two distant supporting structures,
- at least one electrical conductor wire carried by the two distant supporting structures,
the method comprising:
- measuring at least one physical parameter of the optical fiber, of surroundings of the optical fiber, of the at least one electrical conductor wire, and/or of surroundings of the at least one electrical conductor wire,
- measuring:
   o a measured frequency spectrum of oscillations of the optical fiber between the two supporting structures, and/or
   o a measured frequency spectrum of oscillations of the at least one electrical conductor wire between the two supporting structures,
- deducing a perturbation on the line transmission system, based on the measured frequency spectrum.

The measured frequency spectrum of oscillations of the optical fiber between the two supporting structures can be measured by Distributed Acoustic Sensing on the optical fiber between the two supporting structures.

The measured frequency spectrum of oscillations of the at least one electrical conductor wire between the two supporting structures can be measured by Distributed Acoustic Sensing on the optical fiber between the two supporting structures.

The optical fiber can be:
- a free optical fiber not integral with any one of the at least one electrical conductor wire along a length of the at least one electrical conductor wire so that this free optical fiber has not the same oscillations than any one of the at least one electrical conductor wire between the two supporting structures, or
- an optical fiber integral with one of the at least one electrical conductor wire along a length of the electrical conductor wire so that they have the same oscillations between the two supporting structures.

The line transmission system can further comprise at least one supplementary optical fiber, each supplementary optical fiber being integral with one of the at least one electrical conductor wire along a length of the this electrical conductor wire so that each supplementary optical fiber and its integral electrical conductor wire have the same oscillations between the two supporting structures. The measured frequency spectrum of oscillations of the at least one electrical conductor wire between the two supporting structures can be measured by Distributed Acoustic Sensing on at least one supplementary optical fiber between the two supporting structures.

Deducing a perturbation on the line transmission system, based on the measured frequency spectrum, can comprise deducing a nature and/or a location of the perturbation between the two supporting structures.

Deducing a perturbation on the line transmission system can comprise detecting a deviation of the measured frequency spectrum of oscillations of the optical fiber or of oscillations of the at least one electrical conductor wire from an expected value of this frequency spectrum for the measured at least one physical parameter.

The expected value can be comprised in a stored database comprising:
- the expected frequency spectrum of oscillations of the optical fiber between the two supporting structures, as a function of different values of the at least one physical parameter, and/or
- the expected frequency spectrum of oscillations of the at least one electrical conductor wire between the two supporting structures, as a function of different values of the at least one physical parameter.

Deducing a perturbation on the line transmission system can be done by an artificial intelligence having as input data:
- the at least one measured physical parameter, and
- the measured frequency spectrum of oscillations of the optical fiber between the two supporting structures, and/or the measured frequency spectrum of oscillations of the at least one electrical conductor wire between the two supporting structures.

The method according to the invention can comprise a training of the artificial intelligence based on:
- the at least one measured physical parameter, and
- the measured frequency spectrum of oscillations of the optical fiber between the two supporting structures, and/or the measured frequency spectrum of oscillations of the at least one electrical conductor wire between the two supporting structures.

The at least one physical parameter can comprise:
- a temperature of the optical fiber, preferably measured by a temperature sensor or by distributed temperature sensing on the optical fiber, and/or
- a temperature of the at least one electrical conductor wire, preferably measured by a temperature sensor or by Dynamic Line Rating, and/or
- a speed and/or a direction of wind reaching or surrounding the optical fiber, preferably measured by an anemometer or by a laser imaging detection and ranging system, and/or
- a speed and/or a direction of wind reaching or surrounding the at least one electrical conductor wire, preferably measured by an anemometer or by a laser imaging detection and ranging system, and/or
- solar radiation reaching or surrounding the optical fiber, preferably measured by a solarimeter, and/or
- solar radiation reaching or surrounding the at least one electrical conductor wire, preferably measured by a solarimeter, and/or
- humidity reaching or surrounding the optical fiber, preferably measured by an hygrometer, and/or
- humidity reaching or surrounding the at least one electrical conductor wire, preferably measured by an hygrometer, and/or
- tensile load in the optical fiber, preferably measured by a tensile tester, and/or
- tensile load in the at least one electrical conductor wire, preferably measured by a tensile tester, and/or
- angle of the optical fiber at one or each of the supporting structures, preferably measured by a tiltmeter or an inclinometer (preferably attached to the optical fiber in the vicinity of one of the supporting structure) or by using visual external method and/or
- angle of the at least one electrical conductor wire at one or each of the supporting structures, preferably measured by a tiltmeter or an inclinometer (preferably attached to the at least one electrical conductor wire in the vicinity of one of the supporting structure) or by using visual external method.

An other aspect of the invention concerns a monitoring system for monitoring a line transmission system, the line transmission system comprising :
- two supporting structures distant from each other,
- one optical fiber carried by the two distant supporting structures,
- at least one electrical conductor wire carried by the two distant supporting structures,
the monitoring system comprising:
- at least one sensor arranged for measuring at least one physical parameter of the optical fiber, of surroundings of the optical fiber, of the at least one electrical conductor wire, and/or of surroundings of the at least one electrical conductor wire,
- a frequency measurement device arranged for measuring:
   o a measured frequency spectrum of oscillations of the optical fiber between the two supporting structures, and/or
   o a measured frequency spectrum of oscillations of the at least one electrical conductor wire between the two supporting structures,
- an electronic and/or computer unit arranged and/or configured and/or programmed for deducing a perturbation on the line transmission system, based on the measured frequency spectrum.

The frequency measurement device can comprise a Distributed Acoustic Sensing device arranged for measuring the frequency spectrum of oscillations of the optical fiber between the two supporting structures by Distributed Acoustic Sensing on the optical fiber between the two supporting structures.

The frequency measurement device can comprise a Distributed Acoustic Sensing device arranged for measuring the frequency spectrum of oscillations of the at least one electrical conductor wire between the two supporting structures by Distributed Acoustic Sensing on the optical fiber between the two supporting structures.

The optical fiber can be:
- a free optical fiber not integral with any one of the at least one electrical conductor wire along a length of the at least one electrical conductor wire so that this free optical fiber have not the same oscillations than any one of the at least one electrical conductor wire between the two supporting structures, or
- an optical fiber integral with one of the at least one electrical conductor wire along a length of the this electrical conductor wire so that they have the same oscillations between the two supporting structures.

The line transmission system can further comprise at least one supplementary optical fiber, each supplementary optical fiber being integral with one of the at least one electrical conductor wire along a length of the this electrical conductor wire so that each supplementary optical fiber and its integral electrical conductor wire have the same oscillations between the two supporting structures. The frequency measurement device can comprise a Distributed Acoustic Sensing device arranged for measuring the frequency spectrum of oscillations of the at least one electrical conductor wire between the two supporting structures by Distributed Acoustic Sensing on at least one supplementary optical fiber between the two supporting structures.

The unit can be arranged and/or configured and/or programmed for deducing a nature and/or a location of the perturbation between the two supporting structures.

The unit can be arranged and/or configured and/or programmed for deducing a perturbation on the line transmission system by detecting a deviation of the measured frequency spectrum of oscillations of the optical fiber or of oscillations of the at least one electrical conductor wire from an expected value of this frequency spectrum for the measured at least one physical parameter.

The unit can comprise a stored database, the expected value being comprised in the stored database, said database comprising:
- the expected frequency spectrum of oscillations of the optical fiber between the two supporting structures, as a function of different values of the at least one physical parameter, and/or
- the expected frequency spectrum of oscillations of the at least one electrical conductor wire between the two supporting structures, as a function of different values of the at least one physical parameter.

The unit can comprise an artificial intelligence arranged and/or configured and/or programmed for deducing a perturbation on the line transmission system, this artificial intelligence being arranged and/or configured and/or programmed for having as input data:
- the at least one measured physical parameter, and
- the measured frequency spectrum of oscillations of the optical fiber between the two supporting structures, and/or the measured frequency spectrum of oscillations of the at least one electrical conductor wire between the two supporting structures.

The unit can be arranged and/or configured and/or programmed for training of the artificial intelligence based on:
- the at least one measured physical parameter, and
- the measured frequency spectrum of oscillations of the optical fiber between the two supporting structures, and/or the measured frequency spectrum of oscillations of the at least one electrical conductor wire between the two supporting structures.

The at least one sensor can comprise:
- a temperature sensor or by distributed temperature sensing on the optical fiber arranged for measuring a temperature of the optical fiber, and/or
- a temperature sensor or a Dynamic Line Rating device arranged for measuring a temperature of the at least one electrical conductor wire, and/or
- an anemometer or a laser imaging detection and ranging system arranged for measuring a speed and/or a direction of wind reaching or surrounding the optical fiber, and/or
- an anemometer or by a laser imaging detection and ranging system arranged for measuring a speed and/or a direction of wind reaching or surrounding the at least one electrical conductor wire, and/or
- a solarimeter arranged for measuring solar radiation reaching or surrounding the optical fiber, and/or
- a solarimeter arranged for measuring solar radiation reaching or surrounding the at least one electrical conductor wire, and/or
- an hygrometer arranged for measuring humidity reaching or surrounding the optical fiber, and/or
- an hygrometer arranged for measuring humidity reaching or surrounding the at least one electrical conductor wire, and/or
- a tensile tester arranged for measuring tensile load in the optical fiber, and/or
- a tensile tester arranged for measuring tensile load in the at least one electrical conductor wire, and/or
- a tiltmeter or inclinometer (preferably attached to the optical fiber in the vicinity of one of the supporting structure) arranged for measuring angle of the optical fiber at one or each of the supporting structures, and/or
- by a tiltmeter or inclinometer (preferably attached to the at least one electrical conductor wire in the vicinity of one of the supporting structure)arranged for measuring angle of the at least one electrical conductor wire at one or each of the supporting structures.

### Detailed description of the figures and of realization modes of the invention

Other advantages and characteristics of the invention will appear upon examination of the detailed description of embodiments which are in no way limitative, and of the appended drawings in which:
- Figure 1 illustrates a first embodiment of a monitoring system 1 according to the invention for implementing a first embodiment of a monitoring method according to the invention, for monitoring a line transmission system 2,
- Figure 2 is a side view of the monitoring system 1 of figure 1,
- Figure 3 illustrates schematic measured frequency spectrum obtained with the first embodiment of a method and system according to the invention,
- Figure 4 illustrates schematically an example of difference or deviation between:
   - the measured frequency spectrum (part A of figure 4) of oscillations of the optical fiber 3 and/or of oscillations of the at least one electrical conductor wire 4 obtained with the first embodiment of a method and system according to the invention, and
   - an expected value of this frequency spectrum (part B of figure 4)

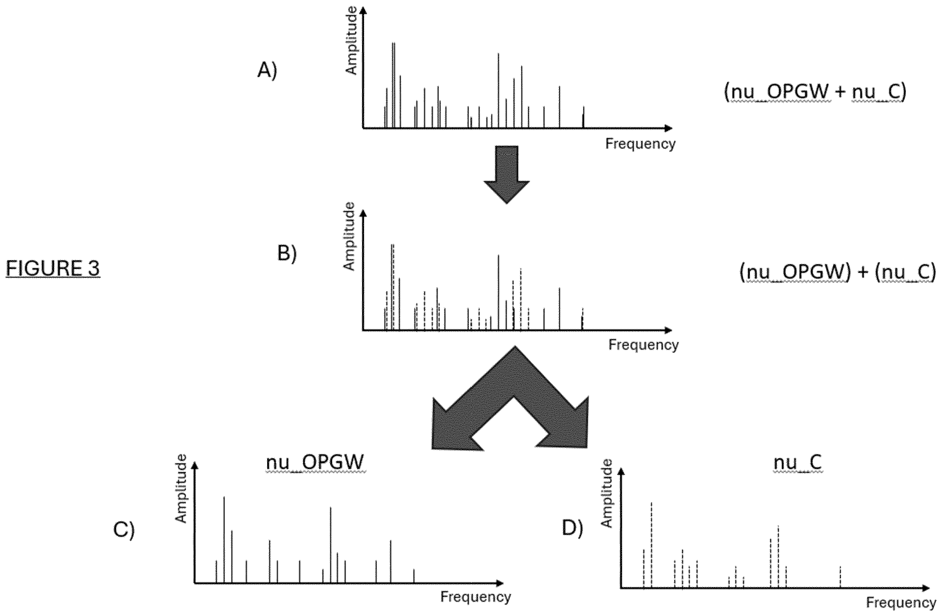

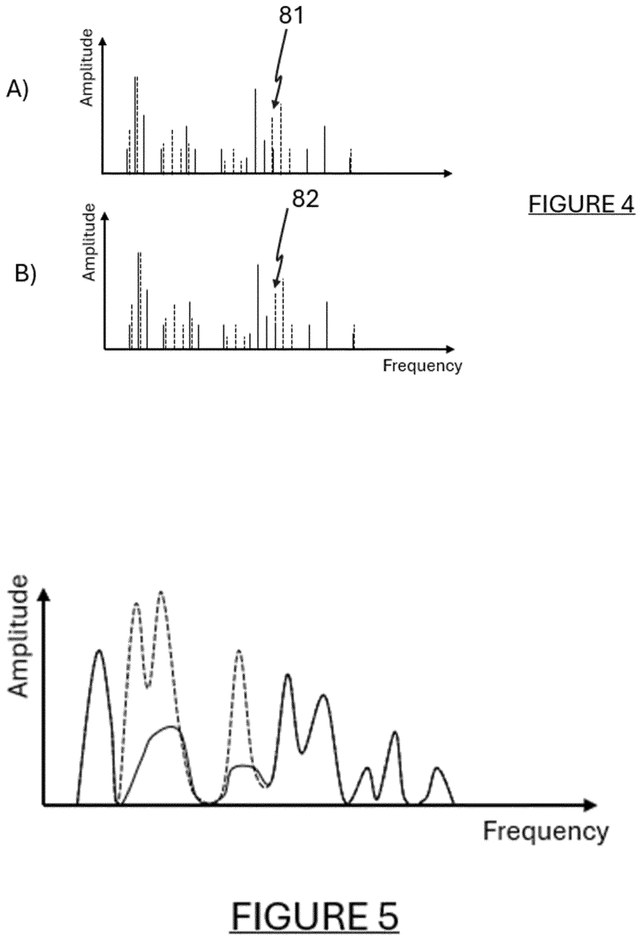

- Figure 5 illustrates that, compared to schematic or theoretical spectrum of figures 3 and 4, each real spectrum is "broadened",

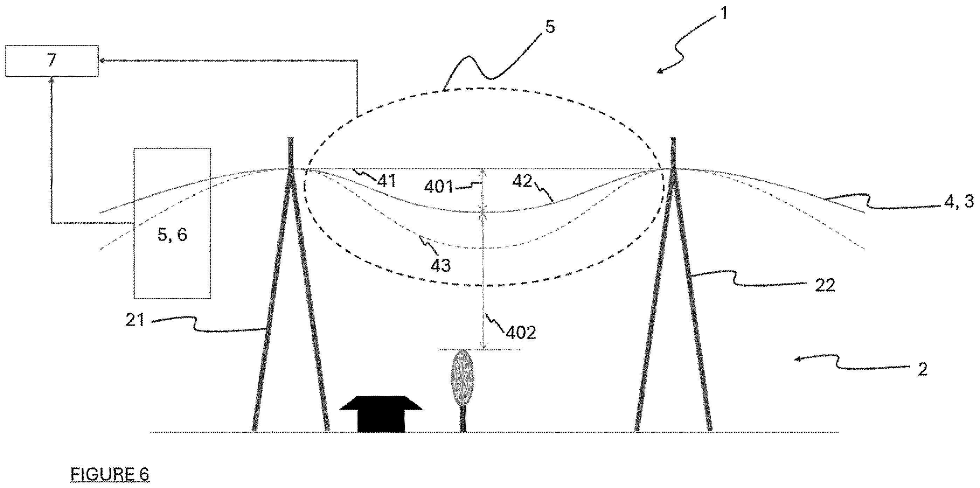

- Figure 6 illustrates a second embodiment of monitoring system 1 for implementing a second embodiment of a monitoring method according to the invention, and

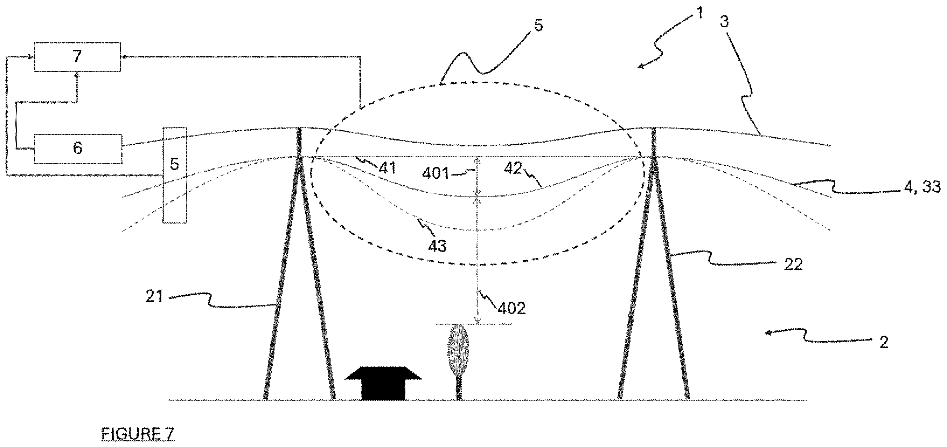

- Figure 7 illustrates a third embodiment of monitoring system 1 for implementing a third embodiment of a monitoring method according to the invention.

These embodiments being in no way limitative, we can consider variants of the invention including only a selection of characteristics subsequently described or illustrated, isolated from other described or illustrated characteristics (even if this selection is taken from a sentence containing these other characteristics), if this selection of characteristics is sufficient to give a technical advantage or to distinguish the invention over the state of the art. This selection includes at least one characteristic, preferably a functional characteristic without structural details, or with only a part of the structural details if that part is sufficient to give a technical advantage or to distinguish the invention over the state of the art.

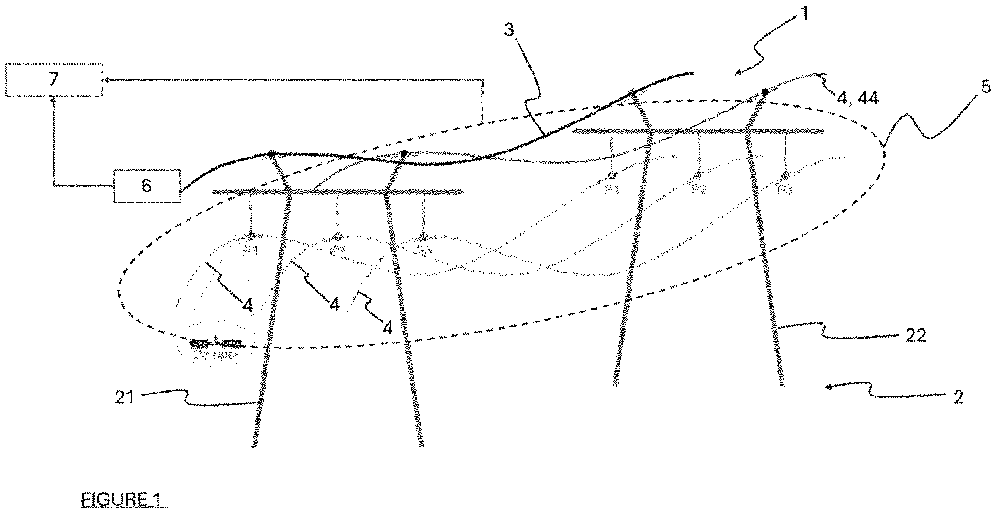

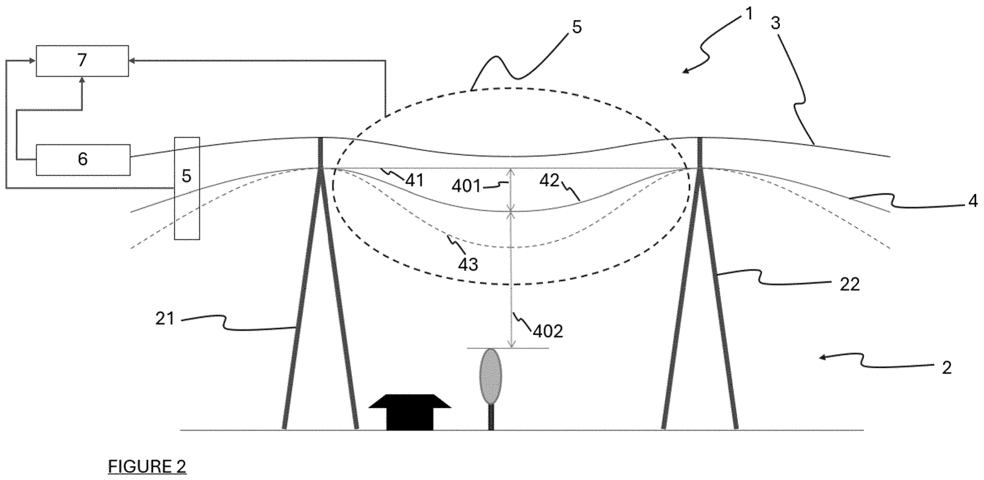

We are now going to describe a, in reference to figures 1 to 5, a first embodiment of a monitoring system 1 according to the invention for implementing a first embodiment of a method according to the invention for monitoring the line transmission system 2 .

The line transmission system 2 comprises :
- two supporting structures 21, 22 distant from each other,
- one optical fiber 3 carried by the two distant supporting structures 21, 22 and between the two distant supporting structures 21, 22,
- at least one electrical conductor wire 4 carried by the two distant supporting structures 21, 22 and between the two distant supporting structures 21, 22.

In this first embodiment according to the invention, optical fiber 3 is for example part of an Optical Ground Wire (OPGW) of system 2, this OPGW combining the optical fiber 3 with an electrical conductor. OPGW is thus a ground wire with integrated fiber 3. It has a double purpose (Ground and communication and/or sensing)

Wire 44 on the top is another ground wire, similar to OPGW but without the optical fiber 3.

The bottom wires 4 (P1/P2/P3) are the electrical wires.

Thus, figure 1 illustrates:
- one electrical conductor wire included in the OPGW, with optical fiber 3, and
- four electrical conductor wires 4, including:
   ∘ **one electrical** ground wire 44 and
   o three other wires 4 conducting electrical current.

This schematic design of figure 1 is inspired by a specific design.

In practice, this example is by no means limiting, and there are almost as many structures or arrangements of electrical transmission line as there are countries in the world, with a wide variety of number and/or type of wires.

Rayleigh scattering is the interaction of a light pulse with material impurities (a typical example would be the scattering of sunlight by dust particles in the atmosphere giving to the sky different colors depending on the incident angle of the sun light). It is the largest of the three backscattered signals in silica fibers and has the same wavelength as the incident light. Rayleigh scattering is the physical principle behind Optical Time Domain Reflectometer (OTDR).

Rayleigh backscattering (RBS) is commonly used to measure propagation loss in fiber. This is the so-called Optical Time Domain Reflectometry (OTDR). This is done by sending a powerful pulse of broadband light (in order words, incoherent light) into a fiber and looking at the averaged RBS.

When the laser has a narrow linewidth (hence, high coherence), then there is enhanced interferometric noise (coherent noise) on the RBS. When looking at a single RBS (almost no averaging, measuring directly or indirectly both intensity and phase of the RBS), the comparison of the coherent noise of successive RBS measurements for any given position along the fiber provides information on the local variation of phase at the corresponding position, and thus the local variation of temperature or strain. Since coherent noise is being scrutinized, the technology became known first as COTDR (Coherent OTDR) in the industry.

The technology has been further developed and one can identify 4 families:
- Phase OTDR, also called DAS-I (DAS for "Distributed Acoustic Sensing" and I for "Intensity"), which:
   o has the disadvantage of a nonlinear response
   o has the disadvantage of Rayleigh fading
   o has the disadvantage of polarization fading
   o allows intensity measurement
   o has the disadvantage of not allowing direct measurement of phase but only phase calculation from mathematical transform of intensity
   o **has the** disadvantage of not allowing measurement of absolute value of temperature or strain but only variations of these physical quantities
   o has the disadvantage of not allowing the direction of the change in temperature or strain or pressure
   o allows direct detection
- Coherent OTDR, also called DAS-*φ* (DAS for "Distributed Acoustic Sensing" and *φ* for "phase"), which:
   o allows linear response
   o has the disadvantage of Rayleigh fading
   o has the disadvantage of polarization fading
   o allows intensity measurement
   o allows phase measurement
   o has the disadvantage of not allowing measurement of absolute value of temperature or strain but only variations of these physical quantities
   o allows coherent detection
   o has the disadvantage of polarization management for coherent detection between signal and local oscillator
- *λ* -scanning OTDR, also called DAS-*λ* (DAS for "Distributed Acoustic Sensing" and *λ* for the wavelength), which:
   o allows linear response
   o has no Rayleigh fading
   o has the disadvantage of polarization fading
   o allows intensity measurement
   o allows spectral shift analysis
   o allows measurement of temperature or strain or pressure
   o allows the direction of the change in temperature or strain or pressure
   o allows direct detection
   o requires a reference measurement
   o has the disadvantage of slow measurement, since it scans
- Chirped pulse OTDR, also called DAS-ch (DAS for "Distributed Acoustic Sensing" and ch for "chirp"), which:
   o allows linear response
   o has no Rayleigh fading
   o has the disadvantage of polarization fading
   o allows intensity measurement
   o allows temporal shift analysis
   o allows measurement of temperature or strain or pressure
   o allows the direction of the change in temperature or strain or pressure
   o allows direct detection
   o requires a reference measurement

In this first embodiment of the method and system according to the invention, optical fiber 3 is a free optical fiber not integral with any one of the at least one electrical conductor wire 4 along a length of each one of the at least one electrical conductor wire 4 so that this free optical fiber 3 has not the same oscillations than any one of the at least one electrical conductor wire 4 between the two supporting structures 21, 22.

Monitoring system 1 comprises transmission system 2.

Monitoring system 1 further comprises:
- at least one sensor 5 arranged for measuring at least one physical parameter of the optical fiber 3, of surroundings of the optical fiber 3, of the at least one electrical conductor wire 4, and/or of surroundings of the at least one electrical conductor wire 4,
- a frequency measurement device 6 arranged for measuring:
   o a measured frequency spectrum (nu_OPGW) of oscillations of the optical fiber 3 between the two supporting structures 21, 22, and/or
   o a measured frequency spectrum (nu_C) of oscillations, between the two supporting structures, of the at least one electrical conductor wire 4 (i.e. for one, part of or each one of the at least one electrical conductor wire 4, with one spectrum per wire 4),
- an electronic and/or computer unit 7 arranged and/or configured and/or programmed for deducing or determining a perturbation on the line transmission system 2, based on the measured frequency spectrum nu_OPGW and/or nu_C.

Unit 7 comprises at least one computer, one central processing or computing unit, one analogue electronic circuit (preferably dedicated), one digital electronic circuit (preferably dedicated) and/or one microprocessor (preferably dedicated) and/or software means.

The at least sensor 5, described in more details below, can have several embodiments and positions, and are therefore illustrated in the figures only imprecisely by an ellipse encompassing several possible positions in the system 1.

Each electrical conductor wire 4 can go down, for example if electrical current in the given wire 4 is too big and the wire 4 is warmer. At some point, the situation can even become unsafe, as for example clearance cannot be guaranteed anymore.

Each wire 4 can thus have different lengths and thus different positions 41, 42, 43 between the structures 21, 22. For a given position of a wire 4 between the structures 21, 22, this wire 4 has:
- a given sag 401 and
- a given clearance 402 above objects on the ground.

Sag 401 of a wire 4 depends on the current intensity running inside this wire 4, the wire electrical resistance, and its ambient conditions. Ambient conditions typically comprise weather conditions like sun exposition and wind cooling factor. The ambient temperature is really influenced by the weather. The sun can warm the wire directly (would become warmer than ambient conditions even without load) and the wind cools down the wire. The temperature Tc of wire 4 is the combination of all this.

Use of Distributed Temperature Sensing (DTS) and Distributed Acoustic Sensing (DAS), alone or in combination, on fiber 3 in the overhead line transmission system 2 allows identifying and localizing potential issues like damper loss, strong wind and induced aeolian vibration, pole tampering / breaking and variation of line sag.

Using Distributed Acoustic Sensing (DAS) on fiber 3, a number of parameters can be measured and used to compute information on the at least one wire 4 and on the condition of the line system 2. This includes identifying the shape of the sag 401 of the fiber 3 and/or of the at least one wire 4 and defaults on the damper. It also allows pole tempering, known as third party intrusion.

The first embodiment of the method and system according to the invention comprises measuring, by the at least one senor 5, at least one physical parameter of the optical fiber 3, of surroundings of the optical fiber 3, of the at least one electrical conductor wire 4, and/or of surroundings of the at least one electrical conductor wire 4.

The at least one physical parameter comprises:
- electrical current running through the at least one wire 4 (current I may be different in each wire 4), and/or
- a temperature (Ta) of the optical fiber 3, preferably measured by the at least one sensor 5 comprising a temperature sensor (typically thermometer) or sensor for implementing distributed temperature sensing (DTS) on the optical fiber 3; using DTS on fiber 3, ambient temperature Ta is known everywhere, preferably taking into account solar and wind, and/or
- a temperature (Tc) of the at least one electrical conductor wire 4 , preferably measured by the at least one sensor 5 comprising a temperature sensor (typically thermometer) or a Dynamic Line Rating (DLR) device (Tc may be different for each wire 4); Unity 7 is arranged and/or configured and/or programmed for computing (and thus computes) Tc from I and possibly other optional characteristics of wire 4; Tc is a combination of ambient temperature Ta on which a term proportional to the load (R.I²), a term proportional to solar radiation and a term related to cooling factor is added (and it is possible to refine with other terms). Tc is for example measured, calculated or determined with a method according to IEEE Std 738^{™}-2023 IEEE Standard for Calculating the Current-Temperature Relationship of Bare Overhead Conductors (here as reference, other descriptions available from CIGRE as well). The computation is given by the heat balance equation: ${q}_{c} + {q}_{r} = {q}_{s} + {I}^{2} R \left({T}_{avg}\right)$ where q_{c} is the convective heat loss, a function of natural convection and forced convection (air cooling), qᵣ is the radiated loss, qₛ is the solar heat gain, I is the load and R the electrical resistance as a function of the cable temperature T_{c}. The standard provides equations for each of the terms under different assumption.
   and/or
- a speed and/or a direction of wind reaching or surrounding the optical fiber 3 , preferably measured by the at least one sensor 5 comprising an anemometer or a laser imaging detection and ranging (LIDAR) system, and/or
- a speed and/or a direction of wind reaching or surrounding the at least one electrical conductor wire 4 (may be different for each wire 4), preferably measured by the at least one sensor 5 comprising an anemometer or a laser imaging detection and ranging (LIDAR) system (may be different for each wire 4), and/or
- solar radiation reaching or surrounding the optical fiber 3, preferably measured by the at least one sensor 5 comprising a solarimeter, and/or
- solar radiation reaching or surrounding the at least one electrical conductor wire 4 (may be different for each wire 4), preferably measured by the at least one sensor 5 comprising a solarimeter (may be different for each wire 4), and/or
- humidity reaching or surrounding the optical fiber 3, preferably measured by the at least one sensor 5 comprising an hygrometer, and which, combined with temperature Ta, could give information on icing, and/or
- humidity reaching or surrounding the at least one electrical conductor wire 4 (may be different for each wire 4), preferably measured by the at least one sensor 5 comprising an hygrometer, and which, combined with temperature Tc, could give information on icing (may be different for each wire 4), and/or
- tensile load in the optical fiber 3, preferably measured by the at least one sensor 5 comprising a tensile tester, and/or
- tensile load in the at least one electrical conductor wire 4 (may be different for each wire 4), preferably measured by the at least one sensor 5 comprising a tensile tester (may be different for each wire 4), and/or
- angle of the optical fiber 3 at one or each of the supporting structures 21, 22, preferably measured by the at least one sensor 5 comprising a tiltmeter or inclinometer (preferably attached to the optical fiber 3 in the vicinity of one of the supporting structure), and/or
- angle of the at least one electrical conductor wire 4 at one or each of the supporting structures (may be different for each wire 4), preferably measured by the at least one sensor 5 comprising a tiltmeter or inclinometer (preferably attached to the at least one electrical conductor wire in the vicinity of one of the supporting structure) (may be different for each wire 4).

The length of fiber 3 (noted L or L_OPGW) is a function of Ta. Unity 7 is arranged and/or configured and/or programmed for computing (and unity 7 thus computes) L_OPGW from Ta, the distance between the poles or supporting structures, the linear weight and the tension of fiber 3.

The sag of fiber 3 (noted D or S_OPGW) is a function of Ta. Unity 7 is arranged and/or configured and/or programmed for computing (and unity 7 thus computes) S_OPGW from Ta, the distance between the poles or supporting structures, the linear weight and the tension of fiber 3.

L_OPGW (also noted L) and/or S_OPGW (also noted D) is for example measured, calculated ou determined with a method according to a method given in H. Argasinska et al., *"Sag-Tension Calculation Methods for Overhead Lines,"* CIGRE, TB324, Apr. 2016. A wire 4 or fiber 3 curve follows a hyperbolic cosine function that can be approximated by a parabolic equation under certain assumption (see TB324). Assuming an x-y coordinate system where x is the horizontal axis, y is the vertical axis, x=0 is the lowest point of the wire 4 or fiber 3 and y is the vertical position of the wire 4 or fiber 3 then the position y(x) of the wire 4 or fiber 3 is $y \left(x\right) ≅ \frac{{wx}^{2}}{2 H}$ where H is the horizontal component of tension in the wire 4 or fiber 3, and w is the weight of the wire 4 or fiber 3 per unit length,
the sag D of wire 4 or fiber 3 is $D ≅ \frac{{wS}^{2}}{8 H}$ where S is the span length of wire 4 or fiber 3 along x axis.

The length of wire 4 or fiber 3 is given by $L ≅ x \left(1+\frac{{x}^{2} {w}^{2}}{{6 H}^{2}}\right)$ L is also impacted by Ta, using the balanced equation with no load, where Ta appears in the heat loss. Applying dilatation coefficient to L, it is then possible to find L(T).

The sag 401 of the at least one wire 4 (noted S_C; in case of several wires, one sag S_C1 or S_C2 or S_C3 etc. is considered for each wire 4) is a function of Ta. Unity 7 is arranged and/or configured and/or programmed for computing (and unity 7 thus computes) S_C from Tc and possibly other optional characteristics of wire 4 such like design, cable length, tension, span between poles and other mechanical parameters.

S_C is calculated using a method similar to that previously explained for calculating the sag of fiber 3.

The first embodiment of the method according to the invention comprises, preferably at the same time than the step of measuring the at least one physical parameter, a step of measuring by the frequency measurement device 6 :
o a measured frequency spectrum (nu_OPGW) of oscillations, between the two supporting structures 21, 22, of the optical fiber 3 and/or
o a measured frequency spectrum (nu_C) of oscillations, between the two supporting structures 21, 22, of the at least one electrical conductor wire 4 (i.e. for one, part of or each one of the at least one electrical conductor wire 4, with one spectrum per wire 4).

Each frequency spectrum nu_OPGW and/or nu_C can be measured directly or indirectly for example through a measurement of the vibrations (of fiber 3 or of the at least one wire 4) from which the spectrum is extracted.

Wind moves fiber 3 and the at least one electrical conductor wire 4 and generates vibrations.

In the case of the first embodiment, the sum of:
- the frequency spectrum (noted nu_OPGW) of oscillations of the optical fiber 3 between the two supporting structures 21, 22, and
- frequency spectrum (noted nu_C) of oscillations of the at least one electrical conductor wire 4 between the two supporting structures 21, 22

is measured by Distributed Acoustic Sensing (DAS) (i.e. by the frequency measurement device (6) comprising a Distributed Acoustic Sensing (DAS) device) on the optical fiber 3 between the two supporting structures 21, 22.

nu_OPGW and nu_C act like a finger print of line system 2 in given condition(s) of temperature, speed and/or a direction of wind, solar radiation, humidity, tensile load, etc., with differentiation of what belongs to fiber 3 and what belongs to the at least one wire 4.

Oscillations from the at least one wire 4 are coupled through poles (connected to each structures 21, 22) on the fiber 3 and are measured, although attenuated, by the DAS device 6.

As Ta and S_C are known as previously described, nu_OPGW and nu_C can be distinguished, preferably through a measurement of nu_measured which is the sum of nu_OPGW + nu_C

The measured frequency spectrum (noted nu_OPGW) of oscillations of the optical fiber 3 between the two supporting structures 21, 22 is thus measured or determined by Distributed Acoustic Sensing (DAS) (i.e. by the frequency measurement device (6) comprising a Distributed Acoustic Sensing (DAS)) on the optical fiber 3 between the two supporting structures 21, 22, preferably through a measurement of nu_measured which is the sum of nu_OPGW + nu_C.

The measured frequency spectrum (noted nu_C) of oscillations of the at least one electrical conductor wire 4 between the two supporting structures is also measured or determined from the same measurement measuring the frequency spectrum (nu_OPGW) of oscillations of the optical fiber 3 between the two supporting structures 21, 22 by Distributed Acoustic Sensing (DAS) on fiber 3, preferably through a measurement of nu_measured which is the sum of nu_OPGW + nu_C.

If fiber 3 is a tight buffer everything previously described applies, but there is the added advantage of more direct access to the tension on fiber 3 or wire 4: nu_OPGW and/or nu_C and/or nu_measured which is the sum of nu_OPGW + nu_C can be measured by Distributed Strain Sensing (DSS) (i.e. by the frequency measurement device (6) comprising a Distributed Sensing System (DSS)) on the optical fiber 3 between the two supporting structures 21, 22.

In case of several electrical conductor wires 4 :
- the measured frequency spectrum (noted nu_C1) of oscillations of the first electrical conductor wire 4 between the two supporting structures is determined from the same measurement measuring the frequency spectrum (nu_OPGW) of oscillations of the optical fiber 3 between the two supporting structures 21, 22,
- the measured frequency spectrum (noted nu_C2) of oscillations of the second electrical conductor wire 4 between the two supporting structures is determined from the same measurement measuring the frequency spectrum (nu_OPGW) of oscillations of the optical fiber 3 between the two supporting structures 21, 22,
- the measured frequency spectrum (noted nu_C3) of oscillations of the third electrical conductor wire 4 between the two supporting structures is determined from the same measurement measuring the frequency spectrum (nu_OPGW) of oscillations of the optical fiber 3 between the two supporting structures 21, 22,
- etc.

In a detailed example, using the DAS, the Rayleigh backscattering is acquired from fiber 3 by device 6, typically one measurement every few milliseconds (depending on the length of fiber 3). The measurement is made by a phase sensitive DAS, (phase-DAS, phi-OTDR, chirped pulsed DAS, etc). From these successive data, the distance-time data set is obtained. If computing the Fourier Transform or Fast Fourier transform (FFT) of these distance-time data, then the spectrum over a time window (typically 1s) is obtained as a function of distance along fiber 3 (at each position).

Usually, the FFT is computed over a certain frequency band only and the energy in this band is displayed as a function of time and distance; this is the waterfall data.

In an ideal case, assuming some wind to make the fiber 3 move, then the spectrum analysis shows some frequencies, which corresponds to the oscillation frequencies of fiber 3 itself. In reality, there will be an overlap of different frequencies related to the different oscillation modes, and the spectrum will depend on the mechanical characteristics of the line system 2 (diameter, tension, metal type, construction, temperature etc).

The device 6 thus measures a signal nu_measured (as illustrated in part A of figure 3) which is in fact the sum of nu_OPGW and the at least one nu_C (as illustrated in part B of figure 3), and unit 7 makes the distinction between nu_OPGW (as illustrated in part C of figure 3) and nu_C (as illustrated in part D of figure 3). This distinction is for example made according to the following method:
- first, a step of theoretical estimation of nu_OPGW and nu_C. For instance in X. Liu, Y. Hu, and M. Cai, "Free vibration analysis of transmission lines based on the dynamic stiffness method," Royal Society Open Science, Mar. 2019 there is provided an finite element modelling (FEM) method of a two span transmission lines based on the catenary, wire or fiber equation (in the non-simplified version) as used for the computation of the line length and sag. The FEM model can be used to analyze the vibration characteristics of the line, providing the oscillation frequencies (resonance mode) of the line, wire or fiber. It is possible to add the amping effect using the FEM approach so that not only the frequencies can be computed but also their amplitudes. Thus, there is a path from the line characteristic to the theoretical spectrum
- then a step comparison of nu_measured with the theoretical estimation of nu_OPGW and nu_C to extract from nu_measured the real contributions of nu_OPGW and nu_C

The spectrum (as illustrated in part A of figure 3) measured from the fiber 3 is a combination of the vibration of fiber 3 and the vibration of the at least one wire 4 coupled through the structures 21, 22. Therefore, by knowing theoretically the fiber spectrum, and similarly the wire spectrum, it is possible to decompose from the measurement what is what.

The first embodiment of the method according to the invention then comprises a step of associating :
o the measured frequency spectrum (nu_OPGW) of oscillations of the optical fiber 3 between the two supporting structures 21, 22, and/or
o the measured frequency spectrum (nu_C) of oscillations of the at least one electrical conductor wire 4 between the two supporting structures 21, 22 (i.e. for one, part of or each one of the at least one electrical conductor wire 4, with one spectrum nu_C per wire 4)
with the measured at least one physical parameter (preferably measured at the same time).

The first embodiment of the method according to the invention comprises deducing or determining, by unit 7, a perturbation on the line transmission system 2, based on the measured frequency spectrum nu_OPGW and/or nu_C and its associated measured at least one physical parameter. In particular, deducing or determining a perturbation on the line transmission system 2, based on the measured frequency spectrum, comprises deducing or determining a nature and/or a location of the perturbation between the two supporting structures 21, 22. The localization of the perturbation is given by the position of the at least one sensor 5 and/or by the continuous localization capabilities of the used Distributed Temperature Sensing (DTS) combined with Distributed Acoustic Sensing (DAS) and/or by a typical signature of the difference between measured spectrum and expected spectrum.

Deducing or determining a perturbation on the line transmission system 2 comprises detecting a deviation of the measured frequency spectrum of oscillations of the optical fiber 3 or of oscillations of the at least one electrical conductor wire 4 from an expected value of this frequency spectrum of oscillations of the optical fiber 3 or of oscillations of the at least one electrical conductor wire 4 for the measured at least one physical parameter.

In a first variant of the first embodiment, unit 7 comprises a stored database , and the expected value is comprised in the stored database and comprises:
- the expected frequency spectrum of oscillations of the optical fiber 3 between the two supporting structures 21, 22, as a function of different values of the associated at least one physical parameter, and/or
- the expected frequency spectrum of oscillations of the at least one electrical conductor wire 4 between the two supporting structures 21, 22 (i.e. for one, part of or each one of the at least one electrical conductor wire 4, with one spectrum nu_C per wire 4), as a function of different values of the associated at least one physical parameter.

In a second variant of the first embodiment (possibly combinable with the first variant) unit 7 comprises an artificial intelligence , and deducing or determining a perturbation on the line transmission system 2 is done by the artificial intelligence having as input data:
- the measured frequency spectrum (nu_OPGW) of oscillations of the optical fiber 3 between the two supporting structures 21, 22, and/or the measured frequency spectrum (nu_C) of oscillations of the at least one electrical conductor wire 4 between the two supporting structures 21, 22 (i.e. for one, part of or each one of the at least one electrical conductor wire 4, with one spectrum nu_C per wire 4), and
- the associated at least one measured physical parameter.

Preferably, this second variant comprises a training, by unit 7, of the artificial intelligence based on (as ground truth) :
- the measured frequency spectrum (nu_OPGW) of oscillations of the optical fiber 3 between the two supporting structures 21, 22, and/or the measured frequency spectrum (nu_C) of oscillations of the at least one electrical conductor wire 4 between the two supporting structures 21, 22 (i.e. for one, part of or each one of the at least one electrical conductor wire 4, with one spectrum nu_C per wire 4),
- the associated at least one measured physical parameter.

With experience and field data, it becomes possible to relate changes in the data to the type of perturbation. Unit 7 uses Artificial Intelligence (AI) methods to help detect changes and possibly recognize changes from previous measurement data. The artificial intelligence of unit 7 typically includes:
- a deep artificial neural network (e.g., including but not limited to Feedforward Neural Network (FNN), Convolutional Neural Network (CNN), Recurrent Neural Network (RNN), or Transformer) trained for classification, regression, or anomaly detection, or
- a classical machine learning classifier, regressor, or anomaly detector (e.g., including but not limited to methods based on decision trees, support vectors, or Gaussian mixture models).

Such a model is trained to compute the desired quantity (class, variable, or anomaly score) by processing the pre-processed DAS and DTS data, derivatives of it (e.g., including but not limited to encoding, or transformation), or features computed from it. The training is done by minimizing a loss function, such as the quadratic error, cross-entropy, a handcrafted specific loss function, or a combination of these, based on a defined training dataset. During this process, optimization methods such as (but not restricted to) backpropagation or Bayesian optimization are used to select the hyper-parameters and parameters of the model. Additionally, part or all of the model can be pre-trained on a dedicated dataset or trained using unsupervised learning by minimizing a loss derived from data-intrinsic statistics or automatically generated labels instead of manually annotated data.

In general, any deviation from the measured spectra with the expected spectra is a signature of perturbation related to damper/line/pole issue.

Similarly, someone climbing one of the structures 21, 22 will perturbate the measurement.

If there is a perturbation on the at least one wire 4, the fingerprint measurement will be changed. There will be thus at least one difference or deviation between:
- the measured frequency spectrum (as illustrated in part A of figure 4) of oscillations of the optical fiber 3 and/or of oscillations of the at least one electrical conductor wire 4, and
- an expected value of this frequency spectrum (as illustrated in part B of figure 4)
for the measured at least one physical parameter associated with the measured frequency spectrum of oscillations of the optical fiber 3 and/or of oscillations of the at least one electrical conductor wire 4. This can be an change in the position of the harmonics (the line is changing length, which we can work out from the external temperature for instance). It can be a change in the amplitudes as well. For instance, each wire 4 has damper that prevent oscillations. If the damper fails, some additional harmonics are likely to appear. The difference is a signature. Relating it to the damper depends on the knowledge of the wire 4. Unit 7 can model each wire 4 with and without damper and identify the theoretical change. If it happens, then it is understood. It is also possible to approach this more pragmatically by looking at changes. It there is a big change, then one can do a wire inspection and find out that a damper is missing, and from then understand what happened.

A fiber 3 is well known from a mechanical/thermal point of view, it is possible to compute the theoretical spectrum and to compare it with the measured one. A deviation of expected nu_OPGW is a signature of perturbation, for instance damper loss, climbing on tower, etc.

A deviation of expected nu_C of a given wire 4 means that the corresponding wire 4 does not behave as it should, for example:
- the wire 4 is warmer/colder then expected due to local sun exposure / wind cooling effect. Therefore the sag may 401 not be guaranteed (load must be reduced) or more load could be transported, and/or
- damper loss.

If there are enough differences in the several nu_C of several wires 4 (for example nu_C1 nu_C2 nu_C3), then unit 7 works out which wire 4 as a defect (which one is deviating from the theory) and what the defect is.

In particular, it is expected that:
- A damper loss brings a unique signature as some vibration modes become possible that were not before (new frequencies will appear in the spectra).
- A pole issue (break, climbing etc) is likely to alter all the nu_OPGW & nu_Ci (i being an integer corresponding to the number of the considered wire 4) similarly (the pole is attached to all wires)
- Changes in the sag of one wire (one being locally more expose to sun or wind) will act on the wire only by moving the frequency distribution.
- Strong aeolian induced vibration will increase the amplitude of some / all resonance frequencies,
and therefore the identification of the specific failure type, based on specific deviation from expected signature(s) nu_OPGW and/or nu_C.

Thus, according to the first embodiment, the use DTS on fiber 3 to grab in situ information on local temperature (sun heating and wind cooling/heating) in combination with the use of DAS on fiber 3 allow to localize issues along an overhead wire 4 whilst identifying the potential hazard or failure.

Of course, each spectrum previously illustrated in figures 3 and 4 is a theoretical spectrum. As illustrated in figure 5, each real spectrum is "broadened".

We are now going to describe a, in reference to figure 6, a second embodiment of a monitoring system 1 according to the invention for implementing a second embodiment of a method according to the invention for monitoring the line transmission system 2.

This second embodiment of the method and device according to the invention will only be described for its differences from the first embodiment previously described.

In this second embodiment, the optical fiber 3 is an optical fiber integral with one of the at least one electrical conductor wire 4 along a length of the this electrical conductor wire 4 so that fiber 3 and this wire 4 have the same oscillations between the two supporting structures 21, 22.

Fiber 3 can be loose or tight with respect to the wire 4 it is integral with. If loose, DAS is preformed, if tight possibly DAS and/or DSS is performed.

In this case, normally, nu_OPGW is equal to nu_C.

This simplifies the measurement to more directly arrive at nu_C from the DAS measurement on the fiber 3. The key here is that there is a direct measurement of nu_C rather then having a nu_C superimposed on nu_OPGW. Thus is is expected that the spectrum is measured more accurately (the coupling from the conductor to the OPGW suffers from attenuation and distortion). In this case, one can expect that the measured nu_C is close to the theoretical nu_C

We are now going to describe a, in reference to figure 7, a third embodiment of a monitoring system 1 according to the invention for implementing a third embodiment of a method according to the invention for monitoring the line transmission system 2.

This third embodiment of the method and device according to the invention will only be described for its differences from the first embodiment previously described.

In this third embodiment, fiber 3 remains as a free optical fiber not integral with any one of the at least one electrical conductor wire 4.

Furthermore, the line transmission system 2 further comprises at least one supplementary optical fiber 33, each supplementary optical fiber 33 being integral with one of the at least one electrical conductor wire 4 along a length of the this electrical conductor wire 4 so that each supplementary optical fiber 33 and its integral electrical conductor wire 4 have the same oscillations between the two supporting structures 21, 22.

The measured frequency spectrum (nu_C) of oscillations of the at least one electrical conductor wire 4 between the two supporting structures 21, 22 is measured by Distributed Acoustic Sensing (DAS) on at least one supplementary optical fiber 33 between the two supporting structures 21, 22. The measured frequency spectrum (nu_C) of oscillations of a wire 4 integral with a supplementary optical fiber 33 is measured by Distributed Acoustic Sensing (DAS) on this supplementary optical fiber 33. For each supplementary optical fiber 33, the measured frequency spectrum (nu_C) of oscillations of the wire 4 integral with this supplementary optical fiber 33 is measured by Distributed Acoustic Sensing (DAS) on this supplementary optical fiber 33.

DTS can be used on the same principle than the first embodiment, on fiber 3 (as a refence point) and/or on at least one (or each) supplementary fiber 33.

Furthermore, DAS can be used on the same principle than the first embodiment, on fiber 3 and/or on at least one (or each) supplementary fiber 33.

For each wire 4, DAS implemented on the supplementary fiber 33 integral with this wire 4 will directly gives nu_C (or nu_C1, nu_C2, or nu_C3 of the respectively first, second or third wire 4) of this wire 4.

Of course, the invention is not limited to the examples which have just been described and numerous amendments can be made to these examples without exceeding the scope of the invention.

Of course, the different characteristics, forms, variants and embodiments of the invention can be combined with each other in various combinations to the extent that they are not incompatible or mutually exclusive.

## Claims

1. Method for monitoring a line transmission system (2), the line transmission system (2) comprising :
- two supporting structures (21, 22) distant from each other,
- one optical fiber (3) carried by the two distant supporting structures,
- at least one electrical conductor wire (4) carried by the two distant supporting structures,
the method comprising:
- measuring at least one physical parameter of the optical fiber, of surroundings of the optical fiber, of the at least one electrical conductor wire, and/or of surroundings of the at least one electrical conductor wire,
- measuring:
o a measured frequency spectrum (nu_OPGW) of oscillations of the optical fiber between the two supporting structures, and/or
o a measured frequency spectrum (nu_C) of oscillations of the at least one electrical conductor wire between the two supporting structures,
- deducing a perturbation on the line transmission system, based on the measured frequency spectrum.

2. The method according to claim 1, **characterized in that** the measured frequency spectrum (nu_OPGW) of oscillations of the optical fiber between the two supporting structures is measured by Distributed Acoustic Sensing (DAS) on the optical fiber between the two supporting structures.

3. The method according to any one of the previous claims, **characterized in that** the measured frequency spectrum (nu_C) of oscillations of the at least one electrical conductor wire between the two supporting structures is measured by Distributed Acoustic Sensing (DAS) on the optical fiber between the two supporting structures.

4. The method according to any one of the previous claims, **characterized in that** the optical fiber is:
- a free optical fiber not integral with any one of the at least one electrical conductor wire along a length of the at least one electrical conductor wire so that this free optical fiber has not the same oscillations than any one of the at least one electrical conductor wire between the two supporting structures, or
- an optical fiber integral with one of the at least one electrical conductor wire along a length of the this electrical conductor wire so that they have the same oscillations between the two supporting structures.

5. The method according to any one of the previous claims, **characterized in that** the line transmission system further comprises at least one supplementary optical fiber (33), each supplementary optical fiber being integral with one of the at least one electrical conductor wire along a length of the this electrical conductor wire so that each supplementary optical fiber and its integral electrical conductor wire have the same oscillations between the two supporting structures.

6. The method according to claim 5, **characterized in that** the measured frequency spectrum (nu_C) of oscillations of the at least one electrical conductor wire between the two supporting structures is measured by Distributed Acoustic Sensing (DAS) on at least one supplementary optical fiber between the two supporting structures.

7. The method according to any one of the previous claims, **characterized in that** deducing a perturbation on the line transmission system, based on the measured frequency spectrum, comprises deducing a nature and/or a location of the perturbation between the two supporting structures.

8. The method according to any one of the previous claims, **characterized in that** deducing a perturbation on the line transmission system comprises detecting a deviation of the measured frequency spectrum of oscillations of the optical fiber or of oscillations of the at least one electrical conductor wire from an expected value of this frequency spectrum for the measured at least one physical parameter.

9. The method according to claim 8, **characterized in that** the expected value is comprised in a stored database comprising:
- the expected frequency spectrum of oscillations of the optical fiber between the two supporting structures, as a function of different values of the at least one physical parameter, and/or
- the expected frequency spectrum of oscillations of the at least one electrical conductor wire between the two supporting structures, as a function of different values of the at least one physical parameter.

10. The method according to any one of the previous claims, **characterized in that** deducing a perturbation on the line transmission system is done by an artificial intelligence having as input data:
- the at least one measured physical parameter, and
- the measured frequency spectrum (nu_OPGW) of oscillations of the optical fiber between the two supporting structures, and/or the measured frequency spectrum (nu_C) of oscillations of the at least one electrical conductor wire between the two supporting structures.

11. The method according to claim 10, **characterized in that** it comprises a training of the artificial intelligence based on:
- the at least one measured physical parameter, and
- the measured frequency spectrum (nu_OPGW) of oscillations of the optical fiber between the two supporting structures, and/or the measured frequency spectrum (nu_C) of oscillations of the at least one electrical conductor wire between the two supporting structures.

12. The method according to any one of the previous claims, **characterized in that** the at least one physical parameter comprise:
- a temperature (Ta) of the optical fiber (3), preferably measured by a temperature sensor or by distributed temperature sensing (DTS) on the optical fiber (3), and/or
- a temperature (Tc) of the at least one electrical conductor wire, preferably measured by a temperature sensor or by Dynamic Line Rating (DLR), and/or
- a speed and/or a direction of wind reaching or surrounding the optical fiber, preferably measured by an anemometer or by a laser imaging detection and ranging (LIDAR) system, and/or
- a speed and/or a direction of wind reaching or surrounding the at least one electrical conductor wire, preferably measured by an anemometer or by a laser imaging detection and ranging (LIDAR) system, and/or
- solar radiation reaching or surrounding the optical fiber, preferably measured by a solarimeter, and/or
- solar radiation reaching or surrounding the at least one electrical conductor wire, preferably measured by a solarimeter, and/or
- humidity reaching or surrounding the optical fiber, preferably measured by an hygrometer, and/or
- humidity reaching or surrounding the at least one electrical conductor wire, preferably measured by an hygrometer, and/or
- tensile load in the optical fiber, preferably measured by a tensile tester, and/or
- tensile load in the at least one electrical conductor wire, preferably measured by a tensile tester, and/or
- angle of the optical fiber at one or each of the supporting structures, preferably measured by a tiltmeter or an inclinometer, and/or
- angle of the at least one electrical conductor wire at one or each of the supporting structures, preferably measured by a tiltmeter or an inclinometer.

13. Monitoring system (1) for monitoring a line transmission system (2), the line transmission system comprising :
- two supporting structures (21,22) distant from each other,
- one optical fiber (3) carried by the two distant supporting structures,
- at least one electrical conductor wire (4) carried by the two distant supporting structures,
the monitoring system comprising:
- at least one sensor (5) arranged for measuring at least one physical parameter of the optical fiber, of surroundings of the optical fiber, of the at least one electrical conductor wire, and/or of surroundings of the at least one electrical conductor wire,
- a frequency measurement device (6) arranged for measuring:
o a measured frequency spectrum (nu_OPGW) of oscillations of the optical fiber between the two supporting structures, and/or
o a measured frequency spectrum (nu_C) of oscillations of the at least one electrical conductor wire between the two supporting structures,
- an electronic and/or computer unit (7) arranged and/or configured and/or programmed for deducing a perturbation on the line transmission system, based on the measured frequency spectrum.

14. The monitoring system according to claim 13, **characterized in that** the frequency measurement device (6) comprises a Distributed Acoustic Sensing (DAS) device arranged for measuring the frequency spectrum (nu_OPGW) of oscillations of the optical fiber between the two supporting structures by Distributed Acoustic Sensing (DAS) on the optical fiber between the two supporting structures.

15. The monitoring system according to any one of claims 13 to 14, **characterized in that** the frequency measurement device (6) comprises a Distributed Acoustic Sensing (DAS) device arranged for measuring the frequency spectrum (nu_C) of oscillations of the at least one electrical conductor wire between the two supporting structures by Distributed Acoustic Sensing (DAS) on the optical fiber between the two supporting structures.
